# EUROPEAN PATENT SPECIFICATION

(11) **EP 3 340 385 B1**
(45) Date of publication and mention of the grant of the patent: **09.08.2023**
(21) Application number: 16836658.1
(22) Date of filing: 18.08.2016
(51) Int. Cl.: H01Q 15/00, B82Y 30/00, C01B 3/02, H05K 9/00, C09K 3/00

(54) **TERAHERTZ METAMATERIAL**
TERAHERTZ-METAMATERIAL
MÉTA-MATÉRIAU POUR TÉRAHERTZ

(30) Priority: 20.08.2015 CN 201510514703
(43) Date of publication of application: 27.06.2018
(73) Proprietor: Kuang-Chi Institute of Advanced Technology, Shenzhen, Guangdong 518000 (CN); Kuang-chi Innovative Technology Ltd., Shenzhen, Guangdong 518000 (CN)
(72) Inventor: LIU, Ruopeng, Shenzhen Guangdong 518057 (CN); XIONG, Wei, Shenzhen Guangdong 518057 (CN); YE, Jincai, Shenzhen Guangdong 518057 (CN); HE, Jiawei, Shenzhen Guangdong 518057 (CN); WANG, Jinjin, Shenzhen Guangdong 518057 (CN); CHEN, Jiangbo, Shenzhen Guangdong 518057 (CN); ZHANG, Shuyuan, Shenzhen Guangdong 518057 (CN)
(74) Representative: Goddar, Heinz J.
(86) International application number: PCT/CN2016/095805
(87) International publication number: WO 2017/028794

(56) References cited:
- CN-A- 103 700 951
- CN-A- 103 700 951
- CN-A- 104 505 598
- CN-A- 104 505 598
- CN-A- 104 678 598
- CN-A- 104 735 964
- CN-A- 104 735 964
- CN-U- 204 857 970
- US-A1- 2010 271 692
- US-A1- 2013 240 251
- US-A1- 2015 151 525
- ZHOU, KESHENG ET AL.: 'NANO-INORGANIC MATTER/POLYMER COMPOSITE MATERIALS WITH ELECTROMAGNETIC WAVE ABSORPTION FUNCTION.' POLYMERIC MATERIALS SCIENCE & ENGINEERING. vol. 18, no. 03, May 2002, page 16, XP009509203

## Description

### TECHNICAL FIELD

The present invention relates to the field of electromagnetic communications, and specifically, to a terahertz metamaterial.

### BACKGROUND

The terahertz band (Terahertz, THz) refers to an electromagnetic wave whose frequency is in a range of 0.1 THz to 10 THz, a wavelength of the terahertz band covers 3 mm to 30 µm, and the terahertz band is also called THz radiation, a sub-millimeter wave, or a T-ray. The terahertz band is between a millimeter wave and an infrared wave in an electromagnetic spectrum, and is not widely used in the field of electromagnetic communications when compared with the two bands: the millimeter wave and the infrared wave.

For a reason of limited application of the terahertz band, mainly being constrained by a terahertz generating source, a detector, and a functional device, the terahertz band has not yet been used on a large scale. In addition, because a terahertz wavelength is very short, a terahertz device has a much smaller size when compared with a microwave device. That is, the size of the terahertz device may be on an order of a few percents of a size of the microwave device. Therefore, it is very difficult to process the terahertz device, and a cost is high.

Therefore, in the prior art, most of the terahertz devices are obtained by using a photolithography method. However, this causes problems of a small sample size and a low yield rate, and this obviously constrains in-depth research and wide application of a terahertz technology greatly.

For problems in the prior art of being difficult to process a terahertz device, an expensive price, and being adverse to application of a terahertz technology in the field of electromagnetic communications, currently, no effective solution is yet proposed.

US2013/240251A1 discloses silk electronic components and methods for fabricating the same. The silk electronic components can be used as novel devices, such as implautable bioelectric and/or biophotonic devices, biosensors, surveillance devices, invisible cloaks, electromagnetic concentrators or antemias.

US2013/240251A1 discloses silk electronic components and methods for fabricating the same. The silk electronic components can be used as novel devices, such as implautable bioelectric and/or biophotonic devices, biosensors, surveillance devices, invisible cloaks, electromagnetic concentrators or antemias.

CN104678598A discloses a terahertz modulator, and a preparation method and a tuning method of the terahertz modulator. The terahertz modulator comprises a copper resonance ring array, a vanadium dioxide film, a silicon dioxide substrate, a broadband terahertz source and a pumping laser source, wherein the copper resonance ring array and the silicon dioxide substrate form a metamaterial; and the rear surface of the silicon dioxide substrate is plated with the vanadium dioxide film. The terahertz modulator disclosed by the invention is capable of modulating the terahertz intensity of an optically controlled high-speed broadband.

US2015/151525A1 discloses a terahertz metamaterial to perform real-time control of electromagnetic wave propagation, reception and emission, and sensors, circuits, or devices that might otherwise be micro-fabricated or printed. The disclosure includes a method of making such a metamaterial. Based on a flexible substrate a paint layer is printed on a substrate. The paint layer can be made of a dielectric paint or a metallic paint. Examples of metallic paint include colloidal silver conductive ink, gold nanoparticle solution, nickel or tin colloidal particle solution, silver paste or any other metal nanoparticle ink or paste. The use of carbon ink is also mentioned.

CN104678598A discloses a terahertz modulator, and a preparation method and a tuning method of the terahertz modulator. The terahertz modulator comprises a copper resonance ring array, a vanadium dioxide film, a silicon dioxide substrate, a broadband terahertz source and a pumping laser source, wherein the copper resonance ring array and the silicon dioxide substrate form a metamaterial; and the rear surface of the silicon dioxide substrate is plated with the vanadium dioxide film. The terahertz modulator disclosed by the invention is capable of modulating the terahertz intensity of an optically controlled high-speed broadband.

### SUMMARY

To resolve the foregoing problems in the prior art, the present invention proposes a terahertz metamaterial, which can simplify processing steps of a terahertz device, reduce a processing cost, and can be widely used in the field of electromagnetic communications.

The technical solutions of the present invention are realized in this way:
According to one aspect of the present invention, a terahertz metamaterial according to claim 1 is provided Further aspects of the metamaterial are defined by the dependent claims.

### BRIEF DESCRIPTION OF DRAWINGS

To describe the technical solutions in the embodiments of the present invention or in the prior art more clearly, the following briefly introduces the accompanying drawings required for describing the embodiments. Apparently, the accompanying drawings in the following description show merely some embodiments of the present invention, and a person of ordinary skill in the art may still derive other drawings from these accompanying drawings without creative efforts.
FIG 1 is a side view of a terahertz metamaterial according to an embodiment of the present invention; and
FIG. 2 is a top view of the terahertz metamaterial shown in FIG. 1.

### DESCRIPTION OF EMBODIMENTS

The following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by a person of ordinary skill in the art based on the embodiments of the present invention shall fall within the protection scope of the present invention, as long as these other embodiments fall within the scope of the appended claims.

According to an embodiment of the present invention, a terahertz metamaterial is provided.

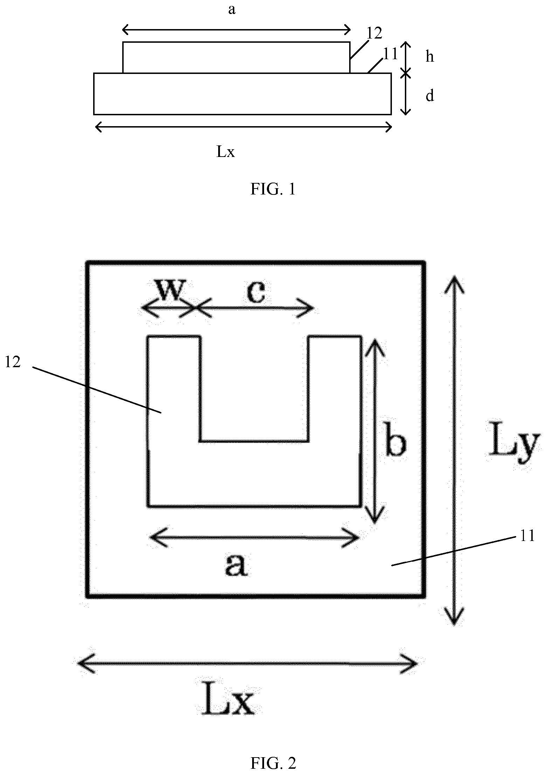

As shown in FIG. 1, the terahertz metamaterial according to the embodiment of the present invention includes:
a substrate 11, and an electromagnetic loss resonant ring structure 12 disposed on an upper surface of the substrate 11, where it can be seen from FIG. 2, which is a top view of the terahertz metamaterial and corresponds to FIG. 1, that, the electromagnetic loss resonant ring structure 12 is a ring structure, and an electromagnetic modulation function can be realized on a terahertz band by adjusting different structural sizes and square resistance of the electromagnetic loss resonant ring structure 12.

For the electromagnetic loss resonant ring structure 12 in the foregoing embodiment, in a production process of the terahertz metamaterial, first, it is necessary to cover an electromagnetic loss film on the substrate 11, and the electromagnetic loss resonant ring structure 12 is processed and made based on the electromagnetic loss film. According to the preferred embodiment, the electromagnetic loss resonant ring structures 12 of different sizes is processed on the electromagnetic loss film, so that a plurality of electromagnetic loss resonant ring structures of different sizes are disposed on the substrate.

It can be seen from the embodiments shown in FIG. 1 and FIG. 2 that, the electromagnetic loss resonant ring structure according to the embodiment of the present invention may be a resonant ring structure that has an opening (FIG.1 and FIG. 2 illustrate a regular resonant ring that has a single opening), but according to a different requirement for electromagnetic modulation, the electromagnetic loss resonant ring structure 12 may also be constructed to be a closed resonant ring structure or a resonant ring structure that has a plurality of openings, so as to adjust a frequency and an amplitude of electromagnetic loss of the terahertz band (0.1 THz to 10 THz).

For example, in a different embodiment, when the electromagnetic loss resonant ring structure is a resonant ring structure that has an opening, the resonant ring structure that has an opening may be U-shaped, V-shaped, C-shaped, inverted h-shaped, L-shaped, y-shaped, or the like.

When the electromagnetic loss resonant ring structure is a closed resonant ring structure, the closed resonant ring structure may be elliptical, closed polygonal, D-shaped, P-shaped, or the like.

Preferably, it can be seen from FIG. 2 that, in this embodiment, the resonant ring structure is a U-shaped regular resonant ring that has a single opening (that is, a single-opening square resonant ring). It can be seen from FIG. 1 that, the single-opening square resonant ring includes two side edges that are parallel and symmetrical to each other and a bottom edge that connects the two side edges. For sizes of the two side edges and the bottom edge, a value range of a length of the side edge herein is between 180 µm to 220 µm, a value range of a width of the side edge is between 40 µm to 60 µm, a value range of a distance between the two side edges is between 180 µm to 220 µm, and a value range of a length of the bottom edge is between 240 µm to 360 µm. In a preferred embodiment, the length and the width of the side edge are, respectively, 200 µm and 50 µm, the distance between the two side edges is 200 µm, and the length of the bottom edge is 300 µm.

Correspondingly, it can be further seen from FIG. 2 that, a thickness h of the electromagnetic loss resonant ring structures 12 is 18 µm.

The square resistance of the electromagnetic loss resonant ring structure shown in FIG. 2 is 200 ohms per square.

Certainly, just an illustrative example is provided herein. That is, the present invention does not limit a specific shape of a resonant ring structure, as long as the electromagnetic loss resonant ring structure is made to be a ring structure, so that a ring structure of a different type can be set according to a different modulation requirement for the terahertz band.

In addition, in one embodiment, for a composition material of the electromagnetic loss film of the foregoing processed electromagnetic loss resonant ring structure, the included material is selected from nano-carbon powder, or a combination of nano-carbon powder and resin That is, the electromagnetic loss film may be made of nano-scale carbon powder, or may be made of a mixture material with nano-scale carbon powder and resin material doped together. Certainly, the composition material of the electromagnetic loss film may also be some other non-metallic materials with an electromagnetic loss function, so that a different non-metallic material can be doped according to a different modulation requirement for the terahertz band. However, only materials selected from nano-carbon powder or a combination of nano-carbon powder and resin fall within the scope of the appended claims.

In the foregoing embodiment, one substrate being disposed with one electromagnetic loss resonant ring structure is used as an example. However, in essence, according to the preferred embodiment, electromagnetic loss resonant ring structures 12 of different sizes are processed on an electromagnetic loss film, so that a plurality of electromagnetic loss resonant ring structures of different sizes are disposed on a substrate. To achieve electromagnetic modulation on the terahertz band, the electromagnetic loss resonant ring structure 12 according to the preferred embodiment of the present invention is arranged on a flexible substrate 11, preferably in a periodical array manner. That is, a terahertz metamaterial according to the preferred embodiment of the present invention includes a plurality of metamaterial unit structures that are shown in FIG. 2 and are arranged, preferably, in the periodical array manner.

In an embodiment, when there are a plurality of electromagnetic loss resonant ring structures, a substrate may be divided into a plurality of cells, one electromagnetic loss resonant ring structure is placed on each cell, and a shape of an electromagnetic loss resonant ring structure placed on each cell may be the same or different.

In addition, it can be seen from FIG. 1 and FIG. 2 that, because the resonant ring structure in this embodiment is a square resonant ring, accordingly, a size of the flexible substrate 11 is designed to be a square structure, and size ranges of a length and a width of the flexible substrate 11 are both between 320 µm to 480 µm. In this embodiment, a preferred length Lx of the flexible substrate 11 is 400 µm, a preferred width Ly is 400 µm, and a size of the upper surface of the flexible substrate 11 may accommodate a resonant ring structure, so that an interval of space exists between the resonant ring structure and an edge of the flexible substrate.

In addition, in an embodiment, to enable the terahertz metamaterial in the present invention to realize electromagnetic modulation on the terahertz band, a substrate 11 according to the preferred embodiment of the present invention is a flexible substrate and preferably, a substrate with a low dielectric constant (the dielectric constant is less than 4.5 but greater than 3.8). For a composition component of the flexible substrate 11, the composition component may be a PI film. Certainly, the composition component may also be made of another flexible material. In this way, the terahertz metamaterial in the present invention can be attached to any curved surface, so that the terahertz metamaterial in the present invention is applied to a wider range of components, is not limited by a shape of a component, and has more universality of application.

In addition, in an embodiment, a terahertz metamaterial according to an embodiment of the present invention further provides two flexible substrates with different toughness. In an embodiment, a value range of a dielectric constant of the flexible substrate is between 2.8 to 4.2, a value range of a loss angle tangent of the flexible substrate is between 0.0048 to 0.0072, and a value range of a thickness of the flexible substrate is between 60 µm to 90 µm. In a preferred embodiment, a dielectric constant of the flexible substrate is 3.5, a loss angle tangent of the flexible substrate is 0.006, and it can be seen from FIG 1 and FIG. 2 that a thickness d of the flexible substrate is 75 µm.

However, in another embodiment, a dielectric constant of a flexible substrate can also be in a range of between 3.44 to 5.16, a value range of a loss angle tangent of the flexible substrate is between 0.0032 to 0.0048, and a value range of a thickness of the flexible substrate is between 32 µm to 48 µm. In a preferred embodiment, a dielectric constant of the flexible substrate is 4.3, a loss angle tangent of the flexible substrate is 0.004, and it can be seen from FIG. 1 and FIG. 2 that a thickness d of the flexible substrate is 40 µm.

In this way, according to a different requirement of a manufactured electromagnetic component, a terahertz metamaterial in the present invention can have different toughness, so that an application environment of the terahertz metamaterial in the present invention is more extensive.

In addition, when a terahertz metamaterial in the present invention performs electromagnetic modulation on the terahertz band (0.1 THz to 10 THz), a factor affecting the electromagnetic modulation function of the terahertz metamaterial may be a size of the electromagnetic loss resonant ring structure 12 (for example, an opening status of a resonant ring, and a specific shape size), may be square resistance of the electromagnetic loss resonant ring structure 12, may also be a periodical arrangement manner of a plurality of the electromagnetic loss resonant ring structures 12 on the substrate 11 (that is, a different periodical arrangement manner), and certainly may also be any combination of the foregoing three factors. That is, the terahertz metamaterial according to the present invention can adjust a frequency and an amplitude of electromagnetic loss of the terahertz band by adjusting the resonant ring structure, square resistance of a non-metallic electromagnetic loss film that constitutes the resonant ring structure, and the arrangement manner of the resonant ring structure on a flexible substrate, thereby realizing electromagnetic adjustment.

In conclusion, by means of the foregoing technical solutions of the present invention, by providing a terahertz metamaterial according to the independent claim the metamaterial with a tuning electromagnetic feature is realized, so that the terahertz metamaterial that is based on an electromagnetic loss resonant ring structure in the present invention has advantages of a light weight, a low cost, and being easy to process. Compared with design of a terahertz metamaterial formed by an electromagnetic loss material that does not have any structure design, design of the terahertz metamaterial that is based on the electromagnetic loss resonant ring structure in the present invention has an advantage of adjustable loss, can control electromagnetic modulation on the terahertz band, and has more actual application values.

The foregoing descriptions are merely exemplary embodiments of the present invention, but are not intended to limit the present invention. Any modification, equivalent replacement, and improvement made without departing from the principle of the present invention shall fall within the protection scope of the present invention, as long as the modification, equivalent replacement or improvement falls within the scope of the appended claims.

## Claims

1. A terahertz metamaterial, comprising:
a substrate (11); and
a plurality of electromagnetic loss resonant ring structures (12) disposed on the substrate (11), wherein
an electromagnetic modulation function is realized on a terahertz band by adjusting different structural sizes and square resistance of the electromagnetic loss resonant ring structures (12),
wherein the substrate (11) comprises a flexible substrate, and the terahertz metamaterial comprises an electromagnetic loss film covering the substrate (11),
the plurality of electromagnetic loss resonant ring structures (12) have different sizes and have been formed by selectively removing parts of the electromagnetic loss film, and a material comprised in the electromagnetic loss resonant ring structures (12) is selected from nano-carbon powder or a combination of nano-carbon powder and resin.

2. The terahertz metamaterial according to claim 1, wherein the electromagnetic loss resonant ring structure (12) is a resonant ring structure that has an opening, and the resonant ring structure that has an opening is U-shaped, V-shaped, C-shaped, inverted h-shaped, L-shaped, or y-shaped.

3. The terahertz metamaterial according to claim 1, wherein the electromagnetic loss resonant ring structure (12) is a closed resonant ring structure, and the closed resonant ring structure is elliptical, closed polygonal, D-shaped, or P-shaped.

4. The terahertz metamaterial according to claim 1, wherein the square resistance of the electromagnetic loss resonant ring structure (12) is 200 ohms per square.

5. The terahertz metamaterial according to claim 1, wherein the plurality of electromagnetic loss resonant ring structures (12) are disposed on the substrate (11), and the plurality of electromagnetic loss resonant ring structures (12) are arranged on the substrate (11) in a periodical array manner.

6. The terahertz metamaterial according to claim 5, wherein the substrate (11) is divided into a plurality of cells, and one electromagnetic loss resonant ring structure (12) is placed on each cell, and the cell is square, and size ranges of a length and a width of the cell are both between 320 µm to 480 µm.

7. The terahertz metamaterial according to claim 1, wherein the flexible substrate (11) comprises a polyimide film.

8. The terahertz metamaterial according to claim 1, wherein a value range of a dielectric constant of the substrate (11) is between 2.8 to 4.2, a value range of a loss angle tangent of the substrate (11) is between 0.0048 to 0.0072, and a value range of a thickness of the substrate (11) is between 60 µm to 90 µm.

9. The terahertz metamaterial according to claim 1, wherein a value range of a dielectric constant of the substrate (11) is between 3.44 to 5.16, a value range of a loss angle tangent of the substrate (11) is between 0.0032 to 0.0048, and a value range of a thickness of the substrate (11) is between 32 µm to 48 µm.

10. The terahertz metamaterial according to claim 7, wherein a factor of the terahertz metamaterial that affects the electromagnetic modulation function on the terahertz band comprises at least one of the following:
a size of the electromagnetic loss resonant ring structure (12);
square resistance of the electromagnetic loss resonant ring structure (12); or
a periodical arrangement manner of the plurality of electromagnetic loss resonant ring structures (12) on the substrate (11).

11. The terahertz metamaterial according to claim 1, wherein the electromagnetic loss resonant ring structure (12) comprises two side edges that are parallel and symmetrical to each other and a bottom edge that connects the two side edges.

12. The terahertz metamaterial according to claim 11, wherein a value range of a length of the side edge is between 180 µm to 220 µm, a value range of a width of the side edge is between 40 µm to 60 µm, a distance between the two side edges is between 180 µm to 220 µm, and a value range of a length of the bottom edge is between 240 µm to 360 µm.

## Patentansprüche

1. Terahertz-Metamaterial, das Folgendes umfasst:
ein Substrat (11); und
eine Vielzahl von Resonanzringstrukturen (12) mit elektromagnetischem Verlust, die auf dem Substrat (11) angeordnet sind, wobei eine elektromagnetische Modulationsfunktion auf einem Terahertz-Band durch Einstellen verschiedener Strukturgrößen und Flächenwiderstände (square resistances) der Resonanzringstrukturen (12) mit elektromagnetischem Verlust realisiert ist,
wobei das Substrat (11) ein flexibles Substrat umfasst, und das Terahertz-Metamaterial einen Film mit elektromagnetischem Verlust umfasst, der das Substrat (11) bedeckt, die Vielzahl der Resonanzringstrukturen (12) mit elektromagnetischem Verlust unterschiedliche Größen haben und durch selektives Entfernen von Teilen des Films mit elektromagnetischem Verlust gebildet worden sind, und ein Material, das in den Resonanzringstrukturen (12) mit elektromagnetischem Verlust enthalten ist, aus Nano-Kohlenstoffpulver oder einer Kombination von Nano-Kohlenstoffpulver und Harz ausgewählt ist.

2. Terahertz-Metamaterial nach Anspruch 1, wobei die Resonanzringstruktur (12) mit elektromagnetischem Verlust eine Resonanzringstruktur ist, die eine Öffnung aufweist, und die Resonanzringstruktur, die eine Öffnung aufweist, U-förmig, V-förmig, C-förmig, invertiert h-förmig, L-förmig oder y-förmig ist.

3. Terahertz-Metamaterial nach Anspruch 1, wobei die Resonanzringstruktur (12) mit elektromagnetischem Verlust eine geschlossene Resonanzringstruktur ist und die geschlossene Resonanzringstruktur elliptisch, geschlossen polygonal, D-förmig oder P-förmig ist.

4. Terahertz-Metamaterial nach Anspruch 1, wobei der Flächenwiderstand der Resonanzringstruktur (12) mit elektromagnetischem Verlust 200 Ohm pro Quadrat beträgt.

5. Terahertz-Metamaterial nach Anspruch 1, wobei die Vielzahl der Resonanzringstrukturen (12) mit elektromagnetischem Verlust auf dem Substrat (11) angeordnet ist und die Vielzahl der Resonanzringstrukturen (12) mit elektromagnetischem Verlust auf dem Substrat (11) in einer periodischen Anordnung angeordnet ist.

6. Terahertz-Metamaterial nach Anspruch 5, wobei das Substrat (11) in eine Vielzahl von Zellen unterteilt ist und eine Resonanzringstruktur (12) mit elektromagnetischem Verlust auf jeder Zelle angeordnet ist, und die Zelle quadratisch ist und die Größenbereiche einer Länge und einer Breite der Zelle beide zwischen 320 µm und 480 µm liegen.

7. Terahertz-Metamaterial nach Anspruch 1, wobei das flexible Substrat (11) einen Polyimidfilm umfasst.

8. Terahertz-Metamaterial nach Anspruch 1, wobei ein Wertebereich einer Dielektrizitätskonstante des Substrats (11) zwischen 2,8 und 4,2 liegt, ein Wertebereich eines Verlustwinkeltangens des Substrats (11) zwischen 0,0048 und 0,0072 liegt und ein Wertebereich einer Dicke des Substrats (11) zwischen 60 µm und 90 µm liegt.

9. Terahertz-Metamaterial nach Anspruch 1, wobei ein Wertebereich einer Dielektrizitätskonstante des Substrats (11) zwischen 3,44 und 5,16 liegt, ein Wertebereich eines Verlustwinkeltangens des Substrats (11) zwischen 0,0032 und 0,0048 liegt und ein Wertebereich einer Dicke des Substrats (11) zwischen 32 µm und 48 µm liegt.

10. Terahertz-Metamaterial nach Anspruch 7, wobei ein Faktor des Terahertz-Metamaterials, der die elektromagnetische Modulationsfunktion auf dem Terahertz-Band beeinflusst, mindestens eines der folgenden umfasst:
Größe der Resonanzringstruktur (12) mit elektromagnetischem Verlust;
den quadratischen Widerstand (square resistance) der Ringstruktur (12) mit elektromagnetischem Verlust; oder
eine periodische Anordnung der Vielzahl von Resonanzringstrukturen (12) mit elektromagnetischem Verlust auf dem Substrat (11).

11. Terahertz-Metamaterial nach Anspruch 1, wobei die Resonanzringstruktur (12) mit elektromagnetischem Verlust zwei Seitenkanten, die parallel und symmetrisch zueinander sind, und eine Bodenkante, die die beiden Seitenkanten verbindet, umfasst.

12. Terahertz-Metamaterial nach Anspruch 11, wobei ein Wertebereich einer Länge der Seitenkante zwischen 180 µm und 220 µm liegt, ein Wertebereich einer Breite der Seitenkante zwischen 40 µm und 60 µm liegt, ein Abstand zwischen den beiden Seitenkanten zwischen 180 µm und 220 µm liegt und ein Wertebereich einer Länge der Bodenkante zwischen 240 µm und 360 µm liegt.

## Revendications

1. Métamatériau de type térahertz, comportant :
un substrat (11) ; et
une pluralité de structures de bagues résonantes à perte électromagnétique (12) disposées sur le substrat (11), dans lequel une fonction de modulation électromagnétique est réalisée sur une bande térahertz en ajustant différentes tailles de structure et la résistance carrée des structures de bagues résonantes à perte électromagnétique (12),
dans lequel le substrat (11) comporte un substrat flexible, et le métamatériau de type térahertz comporte un film à perte électromagnétique recouvrant le substrat (11),
les structures de la pluralité de structures de bagues résonantes à perte électromagnétique (12) ont différentes tailles et ont été formées en retirant de façon sélective des parties du film à perte électromagnétique, et un matériau compris dans les structures de bagues résonantes à perte électromagnétique (12) est sélectionné parmi de la nanopoudre de carbone ou une combinaison de nanopoudre de carbone et de résine.

2. Métamatériau de type térahertz selon la revendication 1, dans lequel la structure de bague résonante à perte électromagnétique (12) est une structure de bague résonante qui a une ouverture, et la structure de bague résonante qui a une ouverture est en forme de U, en forme de V, en forme de C, en forme de h inversé, en forme de L, ou en forme de y.

3. Métamatériau de type térahertz selon la revendication 1, dans lequel la structure de bague résonante à perte électromagnétique (12) est une structure de bague résonante fermée, et la structure de bague résonante fermée est en forme d'ellipse, en forme de polygone fermé, en forme de D ou en forme de P.

4. Métamatériau de type térahertz selon la revendication 1, dans lequel la résistance carrée de la structure de bague résonante à perte électromagnétique (12) est de 200 ohms au carré.

5. Métamatériau de type térahertz selon la revendication 1, dans lequel les structures de la pluralité de structures de bagues résonantes à perte électromagnétique (12) sont disposées sur le substrat (11), et les structures de la pluralité de structures de bagues résonantes à perte électromagnétique (12) sont agencées sur le substrat (11) à la façon d'un réseau périodique.

6. Métamatériau de type térahertz selon la revendication 5, dans lequel le substrat (11) est divisé en une pluralité de cellules, et une structure de bague résonante à perte électromagnétique (12) est placée sur chaque cellule, et la cellule est carrée, et les plages de tailles d'une longueur et d'une largeur de la cellule sont toutes les deux entre 320 µm et 480 µm.

7. Métamatériau de type térahertz selon la revendication 1, dans lequel le substrat flexible (11) comporte un film de polyimide.

8. Métamatériau de type térahertz selon la revendication 1, dans lequel une plage de valeurs d'une constante diélectrique du substrat (11) est entre 2,8 et 4,2, une plage de valeurs d'une tangente d'angle de pertes du substrat (11) est entre 0,0048 et 0,0072, et une plage de valeurs d'une épaisseur du substrat (11) est entre 60 µm et 90 µm.

9. Métamatériau de type térahertz selon la revendication 1, dans lequel une plage de valeurs d'une constante diélectrique du substrat (11) est entre 3,44 et 5,16, une plage de valeurs d'une tangente d'angle de pertes du substrat (11) est entre 0,0032 et 0,0048, et une plage de valeurs d'une épaisseur du substrat (11) est entre 32 µm et 48 µm.

10. Métamatériau de type térahertz selon la revendication 7, dans lequel un facteur du métamatériau de type térahertz qui affecte la fonction de modulation électromagnétique sur la bande térahertz comporte au moins l'un des facteurs suivants :
une taille de la structure de bague résonante à perte électromagnétique (12) ;
une résistance carrée de la structure de bague résonante à perte électromagnétique (12) ; ou
une façon d'agencement périodique de la pluralité de structures de bagues résonantes à perte électromagnétique (12) sur le substrat (11).

11. Métamatériau de type térahertz selon la revendication 1, dans lequel la structure de bague résonante à perte électromagnétique (12) comporte deux bords latéraux qui sont parallèles et symétriques l'un par rapport à l'autre et un bord inférieur qui raccorde les deux bords latéraux.

12. Métamatériau de type térahertz selon la revendication 11, dans lequel une plage de valeurs d'une longueur du bord latéral est entre 180 µm et 220 µm, une plage de valeurs d'une largeur du bord latéral est entre 40 µm et 60 µm, une distance entre les deux bords latéraux est entre 180 µm et 220 µm, et une plage de valeurs d'une longueur du bord inférieur est entre 240 µm et 360 µm.
